# EUROPÄISCHE PATENTANMELDUNG

(11) **EP 0 877 213 A2**
(43) Veröffentlichungstag der Anmeldung: **11.11.1998**
(21) Anmeldenummer: 98890129.4
(22) Anmeldetag: 06.05.1998
(51) Int. Cl.: F24J 2/14, F24J 2/07

(54) **Energiekollektor**

(30) Priorität: 07.05.1997 AT 783/97
(71) Anmelder: ERI Energie-Ressourcen Institut Forschungs- und Entwicklungs-GmbH, 6382 Kirchdorf in Tirol (AT)
(72) Erfinder: Schwarz, Alois, 6382 Kirchdorf/Tirol (AT)
(74) Vertreter: Atzwanger, Richard Dipl.Ing.

(57) **Zusammenfassung**

Energiekollektor bestehend aus einem Gehäuse (1), welches an seiner Oberseite mit einer Abdeckung (11) aus einem für Licht- und Wärmestrahlung durchlässigem Material ausgebildet ist, in dessen Innenraum mindestens ein Wärmekollektor (5) angeordnet ist, welcher von einem von einem Wärmeträger durchströmten Rohr (4) getragen ist, und mit jeweils einem unterhalb des mindestens einen Wärmekollektors (5) angeordneten, konkav ausgebildeten Reflektor, dessen Breite wesentlich größer ist als die Breite des diesem jeweils zugeordneten Wärmekollektors (5), wodurch die einfallende Licht- und Wärmestrahlung entweder auf die Vorderseite des mindestens einen Wärmekollektors (5) auftrifft oder durch den zugeordneten Reflektor (6) auf dessen Rückseite reflektiert wird. Dabei ist zumindest ein Großteil der Rückseite des mindestens einen Wärmekollektors (5) mit photovoltaischen Elementen (7) ausgebildet, welche mittels der konkav ausgebildeten Reflektoren (6) mit gebündelter Lichtenergie beaufschlagt werden (Fig.2).

## Beschreibung

Die gegenständliche Erfindung betrifft einen Energiekollektor bestehend aus einem Gehäuse, welches an seiner Oberseite mit einer Abdeckung aus einem für Licht- und Wärmestrahlung durchlässigen Material ausgebildet ist, in dessen Innenraum mindestens ein Wärmekollektor angeordnet ist, welcher von einem von einem Wärmeträger durchströmbaren Rohr getragen ist, und mit einem unterhalb jedes Wärmekollektors angeordneten, konkav ausgebildeten Reflektor, dessen Breite wesentlich größer ist als die Breite des diesem zugeordneten Wärmekollektors, wodurch die einfallende Licht- und Wärmestrahlung entweder auf die Vorderseite des mindestens einen Wärmekollektors gelangt oder durch den zugeordneten Reflektor auf dessen Rückseite reflektiert wird.

Ein derartiger Energiekollektor ist aus der EU-A1 614 058 bekannt. Dieser bekannte Energiekollektor dient jedoch ausschließlich dazu, den Wärmekollektoren Wärmeenergie zuzuführen, welche mittels des die Rohre durchströmenden Wärmeträgers abgeführt und einer Nutzung zugeführt wird, indem sie z.B. in einer Niedertemperaturheizung verwendet wird oder zur Erzeugung von Warmwasser für Gebrauchszwecke dient.

Es ist weiters bekannt, Lichtenergie mittels photovoltaischer Elemente in elektrische Energie umzuwandeln. Da jedoch der Wirkungsgrad von photovoltaischen Elementen bei über 30°C liegenden Temperaturen stark absinkt, ist es bisher nicht möglich, photovoltaische Elemente mit gebündelter Lichtstrahlung zu beaufschlagen. Vielmehr können aus diesem Grund photovoltaische Elemente nur mit ungebündelter Lichtstrahlung beaufschlagt werden.

Um mittels photovoltaischer Elemente elektrische Energie zu gewinnen, besteht somit das Erfordernis, eine sehr große Anzahl von photovoltaischen Elementen in Serie zu schalten. Hierbei besteht jedoch weiters die Schwierigkeit, daß die Herstellung von photovoltaischen Elementen sehr teuer ist. Diese Sachverhalte bedingen somit, daß die Gewinnung von elektrischer Energie aus Lichtenergie bisher so kostenintensiv ist, daß die bekannte Technologie unwirtschaftlich ist.

Der gegenständlichen Erfindung liegt somit die Aufgabe zugrunde, Maßnahmen zu treffen, durch welche photovoltaische Elemente mit einer gebündelten Lichtstrahlung beaufschlagt werden können, ohne daß hierdurch deren Wirkungsgrad stark abnimmt. Dies wird erfindungsgemäß bei einem Wärmekollektor der eingangs beschriebenen Art dadurch erzielt, daß zumindest auf einem Großteil der Rückseite des mindestens einen Wärmekollektors photovoltaische Elemente vorgesehen sind, welche mittels der konkav ausgebildeten Reflektoren mit gebündelter Lichtenergie beaufschlagt werden.

Dadurch, daß durch die Reflektoren die auf diese auftreffende Lichtstrahlung gebündelt wird, wird den auf der Rückseite der Wärmekollektoren angeordneten photovoltaischen Elementen eine konzentrierte Lichtenergie zugeführt, wodurch ein sehr hoher Wirkungsgrad erzielt wird. Da die den photovoltaischen Elementen gleichzeitig zugeführte Wärmeenergie durch den die Rohre durchströmenden Wärmeträger abgeführt wird, wird gewährleistet, daß die für die Beibehaltung des Wirkungsgrades der photovoltaischen Elemente maximal zulässige Temperatur von 30°C nicht überschritten wird.

Da somit durch einen derartige Energiekollektor sowohl Wärmeenergie als auch mittels der photovoltaischen Elemente elektrische Energie mit gegenüber dem bekannten Stand der Technik wesentlich verringerten Kosten gewonnen werden kann, wird trotz der hohen Kosen bei der Herstellung von photovolatischen Elementen eine sehr hohe Wirtschaftlichkeit in der Gewinnung von elektrischer Energie erzielt.

Vorzugsweise ist die Breite des mindestens einen Wärmekollektors in an sich bekannter Weise einem Sechstel bis der Hälfte der Breite des zugeordneten Reflektors gleich. Vorzugsweise ist weiters der mindestens eine Reflektor in an sich bekannter Weise durch zwei parabelförmig ausgebildete Teilreflektoren gebildet, wobei jedem Teilreflektor eine Hälfte des Wärmekollektors zugeordnet ist. Weiters kann in an sich bekannter Weise jeder Wärmekollektor gegenüber dem zugeordneten Reflektor verdrehbar sein.

Der Gegenstand der Erfindung ist nachstehend anhand zweier in der Zeichnung dargestellter Ausführungsbeispiele näher erläutert. Es zeigen:
- Fig. 1: ein ersten Ausführungsbeispiel einer erfindungsgemäßen Einrichtung, in axonometrischer Darstellung,
- Fig. 2 und 2a: die Einrichtung nach Fig. 1 im Längsschnitt, mit unterschiedlichen Einfallsrichtungen der Licht- und Wärmestrahlung,
- Fig. 3: ein zweites Ausführungsbeispiel einer erfindungsgemäßen Einrichtung, in axonometrischer Darstellung, und die
- Fig. 4 und 4a: die Einrichtung nach Fig. 3 im Längsschnitt, mit unterschiedlichen Einfallsrichtungen der Licht- und Wärmestrahlung.

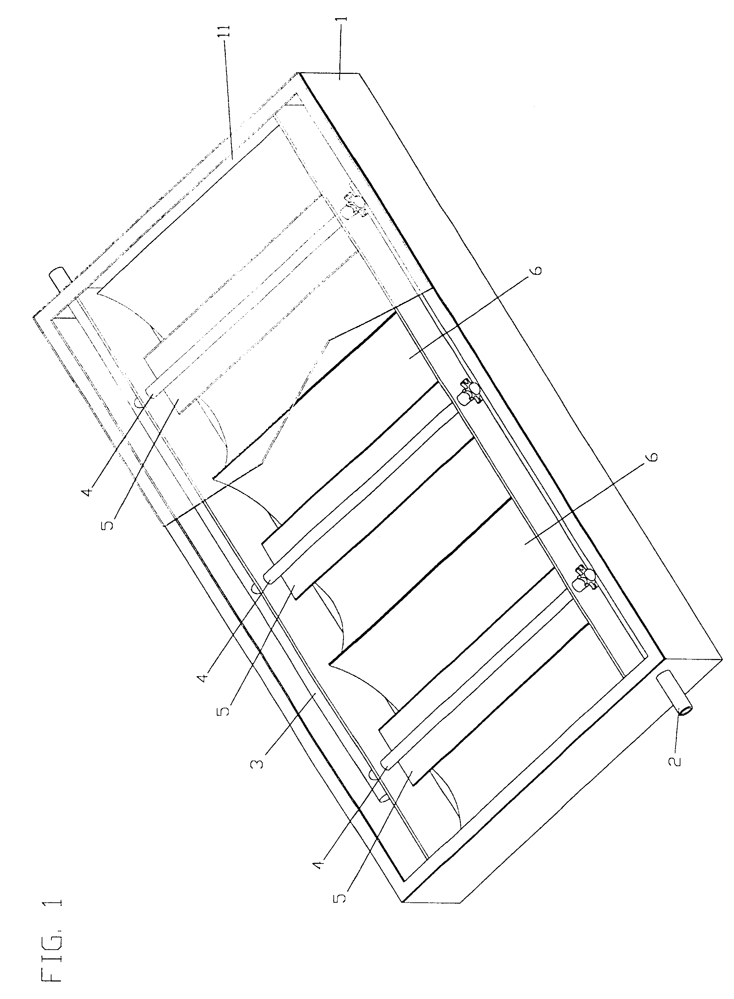

Der in Fig. 1 dargestellte Energiekollektor weist ein quaderförmiges Gehäuse 1 auf, welches an seiner der Einstrahlung von Licht- und Wärmestrahlung zugewandten Oberseite mittels einer Abdeckung 11 aus für Licht- und Wärmestrahlung durchlässigem Material abgedeckt ist. Im Inneren des Gehäuses 1 befinden sich ein Verteilerrohr 2 und ein Sammlerrohr 3, welche durch quer verlaufende Rohre 4 miteinander verbunden sind. Von den Rohren 4 sind plattenförmige Wärmekollektoren 5 getragen. Unterhalb der Wärmekollektoren 4 befinden sich Reflektoren 6.

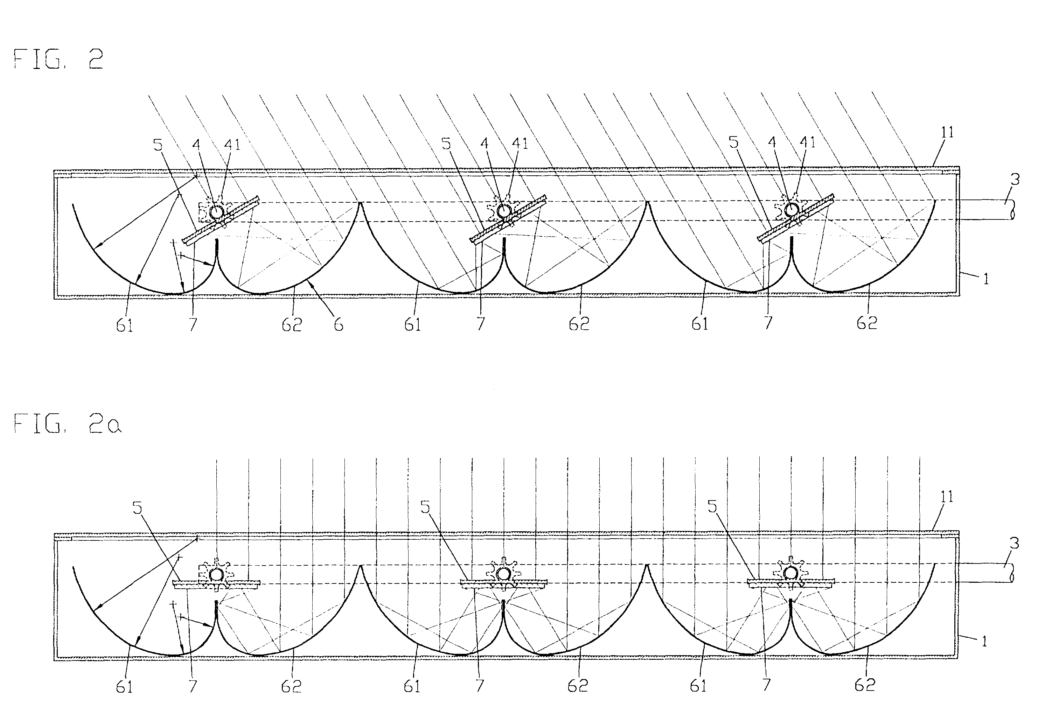

Wie dies weiters aus den Fig. 2 und 2a ersichtlich ist, sind die Wärmekollektoren 5 an der den Reflektoren 6 zugewandten Seite mit einer Vielzahl von photovoltaischen Elementen 7 ausgebildet, welche miteinander in Serie geschaltet sind. Zudem sind die Rohre 4 mit einer Dreheinrichtung in Form eines Zahnrades 41 ausgebildet, wodurch die Wärmekollektoren 5 um die Achse der Rohre 4 verdrehbar sind.

Die Wärmekollektoren 5 weisen eine Breite auf, welche angenähert einem Drittel der Breite des jeweils zugeordneten Reflektors 6 gleich ist. Dabei befinden sich die Wärmekollektoren 5 angenähert zentrisch oberhalb der beiden Reflektoren 6 und unterhalb des oberen Begrenzungsrandes dieser Reflektoren 6. Die unterhalb der Wärmekollektoren 5 angeordneten Reflektoren 6 sind durch jeweils zwei aneinandergefügte, parabelförmig gekrümmte Reflektorteile 61 und 62 gebildet, deren Krümmung so ausgebildet ist, daß die einfallende Licht- und Wärmestrahlung auf die an der Unterseite der Wärmekollektoren 5 befindlichen photovoltaischen Elemente 7 reflektiert wird.

Die Wirkungsweise eines derartigen Energiekollektors ist wie folgt:
Auf das Gehäuse 1 einfallende Licht- und Wärmestrahlung trifft entweder auf die Oberseite der Wärmekollektoren 5 auf, wodurch diese erwärmt werden. Die hierdurch erzeugte Wärme wird durch einen Wärmeträger, welcher durch das Verteilerrohr 2 zuströmt, welcher die Rohre 4 durchströmt und welches durch das Sammlerrohr 3 abströmt, abgeführt, worauf das erwärmte Trägermedium einer Nutzung, z.B. einer Niedertemperaturheizung, einer Wärmepumpe oder einem Speicher für warmes Gebrauchswasser, zugeführt wird.

Die seitlich der Wärmekollektoren einfallende Strahlung wird durch die Reflektorteile 61 und 62 auf die photovoltaischen Elemente 7 reflektiert, in welchen hierdurch elektrischer Strom erzeugt wird. Da durch die konkav ausgebildeten Reflektoren 6 eine Bündelung der einfallenden Lichtstrahlung auf die photovoltaischen Elemente 7 bewirkt wird, wird hierdurch ein sehr hoher Wirkungsgrad erzielt.

Dadurch, daß die auf die photovoltaischen Elemente 7 eingestrahlte Wärmeenergie über die Wärmekollektoren 5 mittels des Wärmeträgers abgeführt wird, wird gewährleistet, daß trotz der auf die photovoltaischen Elemente 7 auftreffenden gebündelten Strahlung die für die photovoltaischen Elemente maximal zulässige Temperatur von 30°C nicht überschritten wird, wodurch diese einen hohen Wirkungsgrad aufweisen.

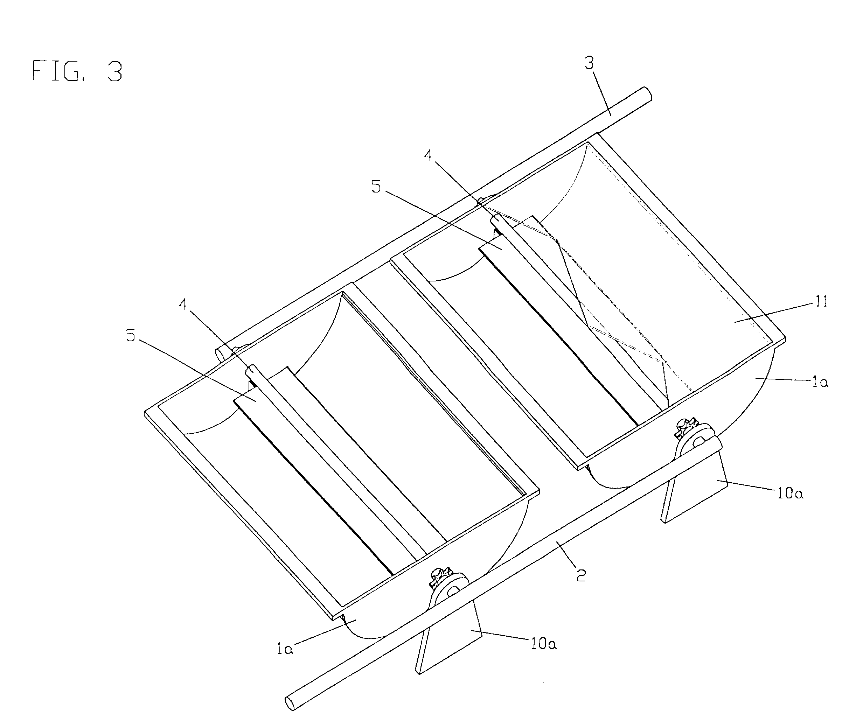

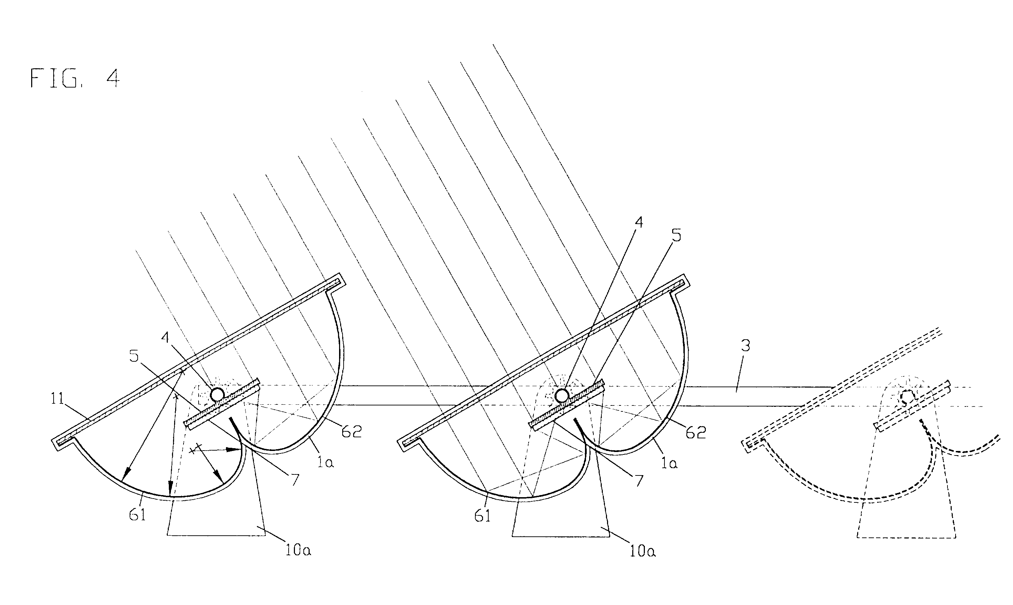

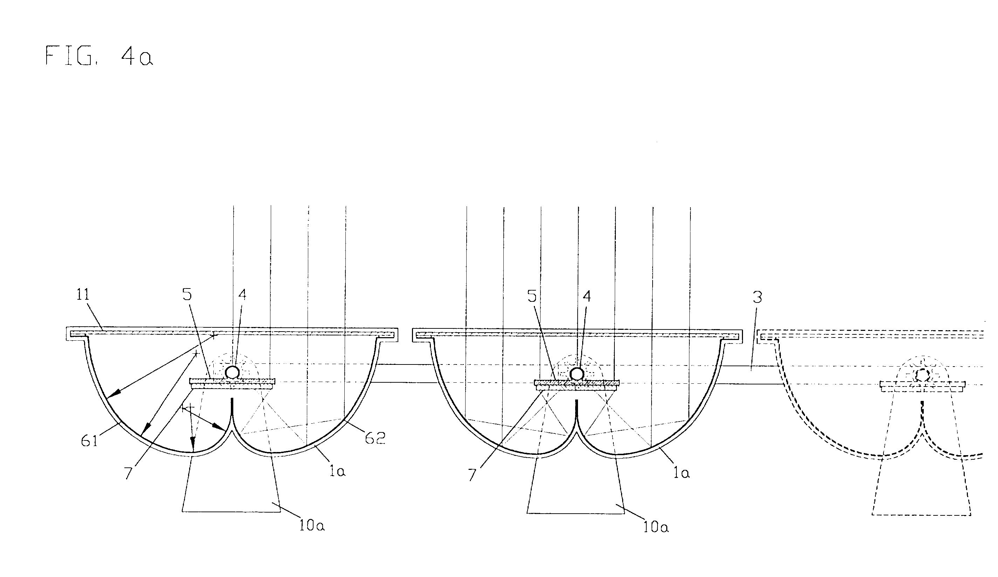

Beim Ausführungsbeispiel gemäß den Fig. 1, Fig. 2 und Fig. 2a ist das quaderförmige Gehäuse auf einem Träger, z.B. auf dem Dach eines Gebäudes, starr befestigt. Um die Wärmekollektoren 5 dem Stand der Sonne nachführen zu können, sind die Wärmekollektoren 5 mittels der Zahnräder 41 um die Achsen der Rohre 4 verdrehbar gelagert.
Beim Ausführungsbeispiel gemäß den Fig. 3, Fig. 4 und Fig. 4a befindet sich jeder Wärmekollektor 5 in einem durch die Reflektoren gebildeten Gehäuse la, welches gegenüber einer Trageinrichtung 10a verdrehbar ist. Die übrige Ausbildung dieser Ausführungsform stimmt mit der vorstehend beschriebenen Ausführungsform weitestgehend überein.

## Patentansprüche

1. Energiekollektor bestehend aus einem Gehäuse (1], welches an seiner Oberseite mit einer Abdeckung (11) aus einem für Licht- und Wärmestrahlung durchlässigem Material ausgebildet ist, in dessen Innenraum mindestens ein Wärmekollektor (5) angeordnet ist, welcher von einem von einem Wärmeträger durchströmten Rohr (4) getragen ist, und mit jeweils einem unterhalb des mindestens einen Wärmekollektors (5) angeordneten, konkav ausgebildeten Reflektor, dessen Breite wesentlich größer ist als die Breite des diesem jeweils zugeordneten Wärmekollektors (5), wodurch die einfallende Licht- und Wärmestrahlung entweder auf die Vorderseite des mindestens einen Wärmekollektors (5) auftrifft oder durch den zugeordneten Reflektor (6) auf dessen Rückseite reflektiert wird, dadurch gekennzeichnet, daß zumindest ein Großteil der Rückseite des mindestens einen Wärmekollektors (5) mit photovoltaischen Elementen (7) ausgebildet ist, welche mittels der konkav ausgebildeten Reflektoren (6) mit gebündelter Lichtenergie beaufschlagt werden.

2. Vorrichtung nach Patentanspruch 1, dadurch gekennzeichnet, daß die Breite des mindestens einen Wärmekollektors (5) in an sich bekannter Weise einem Sechstel bis der Hälfte der Breite des zugeordneten Reflektors (6) gleich ist.

3. Vorrichtung nach einem der Patentansprüche 1 und 2, dadurch gekennzeichnet, daß der mindestens eine Reflektor (6) in an sich bekannter Weise durch zwei parabelförmig ausgebildete Teilreflektoren (61, 62) gebildet ist, wobei jedem Teilreflektor eine Hälfte des Wärmekollektors (5) zugeordnet ist.

4. Vorrichtung nach einem der Patentansprüche 1 bis 3, dadurch gekennzeichnet, daß in an sich bekannter Weise jeder Wärmekollektor (5) gegenüber dem zugeordneten Reflektor (6) verdrehbar ist.
